# EUROPÄISCHE PATENTSCHRIFT

(11) **EP 3 373 023 B1**
(45) Veröffentlichungstag und Bekanntmachung des Hinweises auf die Patenterteilung: **06.05.2020**
(21) Anmeldenummer: 17159463.3
(22) Anmeldetag: 06.03.2017
(51) Int. Cl.: G01R 33/032, G01R 33/12

(54) **SENSOR UND VERFAHREN ZU DESSEN HERSTELLUNG UND VERWENDUNG**
SENSOR AND METHOD FOR ITS PRODUCTION AND APPLICATION
CAPTEUR ET SON PROCÉDÉ DE FABRICATION ET D'UTILISATION

(43) Veröffentlichungstag der Anmeldung: 12.09.2018
(73) Patentinhaber: Fraunhofer-Gesellschaft zur Förderung der angewandten Forschung e.V., 80686 München (DE)
(72) Erfinder: GIESE, Christian, 79115 Freiburg (DE); NEBEL, Christoph E., 79102 Freiburg (DE)
(74) Vertreter: Friese Goeden Patentanwälte PartGmbB

(56) Entgegenhaltungen:
- US-A1- 2011 062 957
- US-A1- 2011 309 265
- ANDREI FARAON ET AL: "Paper;Quantum photonic devices in single-crystal diamond;Quantum photonic devices in single-crystal diamond", NEW JOURNAL OF PHYSICS, INSTITUTE OF PHYSICS PUBLISHING, BRISTOL, GB, Bd. 15, Nr. 2, 7. Februar 2013 (2013-02-07), Seite 25010, XP020238055, ISSN: 1367-2630, DOI: 10.1088/1367-2630/15/2/025010
- TSUKANOV A V ET AL: "Experimental diamond photonics: Current state and prospects. Part II", RUSSIAN MICROELECTRONICS, NEW YORK, NY, US, Bd. 45, Nr. 6, 9. Februar 2017 (2017-02-09), Seiten 367-382, XP036152438, ISSN: 1063-7397, DOI: 10.1134/S1063739716060081 [gefunden am 2017-02-09]
- TIM SCHRÖDER ET AL: "Quantum nanophotonics in diamond [Invited]", JOURNAL OF THE OPTICAL SOCIETY OF AMERICA - B., Bd. 33, Nr. 4, 30. März 2016 (2016-03-30), Seite B65, XP055273893, US ISSN: 0740-3224, DOI: 10.1364/JOSAB.33.000B65
- SANTORI C ET AL: "Nanophotonics for quantum optics using nitrogen-vacancy centers in diamond;Nanophotonics for quantum optics using nitrogen-vacancy centers in diamond", NANOTECHNOLOGY, IOP, BRISTOL, GB, Bd. 21, Nr. 27, 22. Juni 2010 (2010-06-22) , Seite 274008, XP020194459, ISSN: 0957-4484, DOI: 10.1088/0957-4484/21/27/274008
- PAUL E BARCLAY ET AL: "Hybrid photonic crystal cavity and waveguide for coupling to diamond NV-centers", ARXIV.ORG, CORNELL UNIVERSITY LIBRARY, 201 OLIN LIBRARY CORNELL UNIVERSITY ITHACA, NY 14853, 3. April 2009 (2009-04-03), XP080318246, DOI: 10.1364/OE.17.009588

## Beschreibung

Die Anmeldung betrifft einen Sensor auf einem Substrat mit einer ersten Seite und einer gegenüberliegenden zweiten Seite, wobei auf der ersten Seite zumindest ein Wellenleiter angeordnet ist, welcher Diamant enthält oder daraus besteht. Weiterhin betrifft die Erfindung ein Verfahren zur Messung eines Magnetfeldes mit einem Sensor. Schließlich betrifft die Erfindung ein Verfahren zur Herstellung eines Sensors, bei welchem zumindest ein NV-Zentrum in einem Diamant erzeugt wird.

Sensoren und Verfahren der eingangs genannten Art können zur Messung von Magnetfeldern mit hoher örtlicher Auflösung verwendet werden.

Aus der US 2016/0216340 A1 ist ein Sensor bekannt, welcher einen Diamantkristall enthält bzw. daraus besteht. Im Diamant ist ein NV-Zentrum eingebracht. Wenn dieses NV-Zentrum negativ geladen ist, so bilden zwei ungepaarte Elektronen einen Triplett-Zustand. Durch die Spin-Spin-Wechselwirkung umfasst dieser Triplet-Zustand einen Singulett-Zustand mit mₛ = 0 und einen zweifach entarteten Dublett-Zustand mit mₛ = ±1. Durch Anlegen eines Magnetfeldes wird die Entartung des Dubletts aufgehoben, so dass die spektroskopische Analyse des NV-Zentrums grundsätzlich als Magnetfeldsensor verwendbar ist. Weitere Sensoren sind bekannt aus
ANDREI FARAON ET AL: "Paper;Quantum photonic devices in single-crystal diamond;Quantum photonic devices in single-crystal diamond",NEW JOURNAL OF PHYSICS, INSTITUTE OF PHYSICS PUBLISHING, BRISTOL, GB, Bd. 15, Nr. 2, 7. Februar 2013 (2013-02-07), Seite 25010, XP020238055,ISSN: 1367-2630, DOI: 10.1088/1367-2630/15/2/025010;
TSUKANOV A V ET AL: "Experimental diamond photonics: Current state and prospects. Part II",RUSSIAN MICROELECTRONICS, NEW YORK, NY, US, Bd. 45, Nr. 6, 9. Februar 2017 (2017-02-09), Seiten 367-382, XP036152438,ISSN: 1063-7397, DOI: 10.1134/S1063739716060081;
TIM SCHRÖDER ET AL: "Quantum nanophotonics in diamond [Invited]",JOURNAL OF THE OPTICAL SOCIETY OF AMERICA - B., Bd. 33, Nr. 4, 30. März 2016 (2016-03-30), Seite B65, XP055273893,US ISSN: 0740-3224, DOI: 10.1364/JOSAB.33.000B65;
US 2011/062957;
US 2011/309265.

Nachteilig an diesem bekannten Sensor ist jedoch der hohe apparative Aufwand zur Signalerzeugung und -auslese. Dieser Aufwand vergrößert sich weiter, wenn mit einer Vielzahl dieser bekannten Sensoren eine räumliche Feldverteilung eines Magnetfeldes und/oder ein zeitlicher Verlauf bestimmt werden soll.

Ausgehend vom Stand der Technik liegt der Erfindung somit die Aufgabe zugrunde, ein Verfahren und eine Vorrichtung zur Messung eines Magnetfeldes anzugeben, welche einen geringen apparativen Aufwand erfordern und gleichzeitig Messungen mit hoher Sensitivität und sehr guter räumlicher Auflösung ermöglichen.

Die Aufgabe wird erfindungsgemäß durch einen Sensor gemäß Anspruch 1, ein Verfahren nach Anspruch 7 und ein Verfahren nach Anspruch 9 gelöst. Vorteilhafte Weiterbildungen der Erfindung finden sich in den Unteransprüchen.

Erfindungsgemäß wird ein Sensor mit einem Substrat mit einer ersten Seite und einer gegenüberliegenden zweiten Seite vorgeschlagen. Das Substrat kann beispielsweise Glas, Silizium, Siliziumoxid, Siliziumnitrid, Siliziumoxynitrid, Siliziumcarbit und/oder einen III-VI-Verbindungshalbleiter aufweisen. Das Substrat kann homogen aufgebaut sein, d.h. nur aus einer einzigen Materiallage bestehen. In anderen Ausführungsformen der Erfindung kann das Substrat selbst aus mehreren Einzelschichten zusammengesetzt sein. In einigen Ausführungsformen der Erfindung kann das Substrat eine laterale Strukturierung aufweisen und als integrierter Schaltkreis ausgebildet sein bzw. einen integrierten Schaltkreis enthalten.

Auf der ersten Seite des Substrates ist zumindest ein Wellenleiter angeordnet, welcher Diamant enthält oder daraus besteht. Der Wellenleiter kann als Multimode-Wellenleiter und/oder als Singlemode-Wellenleiter ausgebildet sein. Der Wellenleiter enthält zumindest einen Kern. Der Kern ist von einem weiteren Material mit geringerem Brechungsindex umgeben. Dies kann auch Umgebungsluft oder ein Schutzgas sein. Optische Signale werden an den Grenzflächen des Kerns totalreflektiert und auf diese Weise im Inneren des Wellenleiters entlang dessen Längserstreckung geführt.

Anfang und Ende des Wellenleiters können mit je einem Koppelelement versehen werden, welches die Einkopplung optischer Signale aus einer Faseroptik oder einem Freistrahl ermöglicht.

Bei Betrieb des Sensors wird in den Wellenleiter Licht eingekoppelt, welches beispielsweise aus einem Halbleiterlaser, einer Leuchtdiode oder einer Superlumineszenzdiode stammen kann. Das Licht verlässt den Wellenleiter an dessen gegenüberliegenden Ende und wird dort einem Detektor zugeführt. In anderen Ausführungsformen der Erfindung kann das Ende des Wellenleiters auch verspiegelt sein, so dass das reflektierte Signal über den Eingang ausgekoppelt und einer Analyseeinrichtung zugeführt wird. In einigen Ausführungsformen der Erfindung können Spektrometer und/oder Detektoren zur Auslese der optischen Signale auf dem zumindest einem Substrat integriert sein, so dass der Sensor als integrierte optische Komponente ausgeführt werden kann.

Erfindungsgemäß wird nun vorgeschlagen, dass der zumindest eine auf dem Substrat angeordnete Wellenleiter zumindest ein NV-Zentrum enthält. Das NV-Zentrum enthält ein Stickstoffatom, welches auf einem Gitterplatz eines Kohlenstoffatoms des Diamantgitters im Kristall eingebaut ist. Weiterhin enthält das NV-Zentrum eine Leerstelle bzw. eine Vakanz benachbart zum Stickstoffatom. Das neutrale NV-Zentrum enthält somit fünf Elektronen, nämlich drei Bindungselektronen der drei benachbarten Kohlenstoffatome sowie zwei Elektronen des benachbarten Stickstoffatoms. Das negativ geladene NV-Zentrum enthält demnach sechs Elektronen. Zwei dieser sechs Elektronen sind ungepaart und bilden einen Triplett-Zustand. Durch die Spin-Spin-Wechselwirkung enthält dieser Triplett-Zustand einen Singulett-Zustand mit der Gesamtspinquantenzahl mₛ = 0 und einen energetisch darüber angeordneten Dublett-Zustand mit der Spinquantenzahl mₛ = ±1. Dieser Dublett-Zustand ist energetisch entartet, d.h. beide Zustände weisen dieselbe Energie auf.

Die Singulett- und Dublett-Zustände des Tripletts weisen eine energetische Separation von 12 µeV auf. Übergänge zwischen beiden Zuständen können somit mit Mikrowellenstrahlung mit einer Frequenz von 2,88 GHz angeregt werden.

Bei Anwesenheit eines Magnetfeldes wird die energetische Entartung des Dubletts aufgehoben. Die Energiedifferenz beträgt dann ΔE = g.µ.B.

Erfindungsgemäß wird daher vorgeschlagen, ein Magnetfeld mit dem erfindungsgemäßen Sensor dadurch zu detektieren, dass der Sensor bzw. zumindest der Ort des NV-Zentrums mit Mikrowellenstrahlung beaufschlagt wird, um elektronische Übergänge zwischen dem Singulett-Zustand und den Dublett-Zuständen anzuregen. Die erfolgte Anregung kann optisch durch das im Wellenleiter propagierende Signal detektiert werden. Da der Wellenleiter und das NV-Zentrum und optional Teile der für die Signalerzeugung und -auslese benötigten elektronischen Komponenten auf dem Substrat angeordnet sind, ist der erfindungsgemäße Sensor kompakt, mechanisch robust und zuverlässig und kostengünstig herstellbar. In Abhängigkeit des Integrationsgrades kann der Betrieb einfach und zuverlässig erfolgen, da nur wenige externe Komponenten erforderlich sind. Die Sensitivität des NV-Zentrums auf externe Magnetfelder ist hinreichend groß, um auch Magnetfelder zwischen etwa 10 fT und etwa 1 pT zu erfassen. Somit eignet sich der erfindungsgemäße Sensor beispielsweise zur Magnetoenzephalographie. Auf diese Weise können neuronale Aktivitäten eines menschlichen oder tierischen Gehirns nicht-invasiv gemessen werden.

Da die Dipolübergänge zwischen den einzelnen Zuständen des Tripletts des NV-Zentrums nur eine kurze Lebensdauer von wenigen µs aufweisen, ist eine hohe zeitliche Auflösung bei der Bestimmung von Magnetfeldern sichergestellt. Die örtliche Auflösung des erfindungsgemäßen Sensors entspricht der Größe des NV-Zentrums, so dass eine atomare Auflösung ermöglicht wird.

In den Ausführungsformen der Erfindung kann eine Mehrzahl von NV-Zentren einen Sensor definieren. Sofern mehrere NV-Zentren in einem Sensorelement realisiert sind, ergibt sich die räumliche Auflösung aus der Größe des mit NV-Zentren versehenen Volumens. Die Ortsauflösung des erfindungsgemäßen Sensors kann jedoch besser als etwa 1 mm, besser als etwa 100 µm, besser als etwa 10 µm oder besser als etwa 3 µm sein.

In einigen Ausführungsformen der Erfindung kann auf dem Substrat eine Mehrzahl von Wellenleitern angeordnet sein, in welche jeweils zumindest ein zugeordnetes NV-Zentrum eingebracht ist. In einigen Ausführungsformen der Erfindung kann die Anzahl der Wellenleiter zwischen etwa 2 und etwa 30 oder zwischen etwa 5 und etwa 20 oder zwischen etwa 6 und etwa 15 betragen. Somit kann mit einem einzelnen Sensorelement mit einem einzelnen Substrat ein Magnetfeld an einer Vielzahl von definierten Orten bestimmt werden, so dass der erfindungsgemäße Sensor sowohl eine hohe Orts- als auch eine hohe Zeitauflösung ermöglicht. Vorteilhaft ist dabei, dass der erfindungsgemäße Sensor keine Kühlung benötigt und somit auf aufwändige Kryotechnik verzichtet werden kann. Dies ermöglicht insbesondere den Einsatz zur Diagnostik lebender Organismen.

In einigen Ausführungsformen der Erfindung enthält der Wellenleiter einen kristallinen Diamant. Hierdurch werden optische Verluste an Kristall- bzw. Korngrenzen vermieden und dadurch das Signal/Rauschverhältnis verbessert.

In einigen Ausführungsformen der Erfindung kann der Wellenleiter eine Dicke von etwa 3 µm bis etwa 6 µm aufweisen. Solche Schichten können defektarm hergestellt werden, so dass das im Wellenleiter propagierende Licht nur eine geringe Dämpfung erfährt.

In einigen Ausführungsformen der Erfindung kann zwischen dem Substrat und dem Wellenleiter eine Isolationsschicht angeordnet sein. Der Isolator kann einen spezifischen Widerstand zwischen etwa 10⁷ Ω·cm und etwa 10¹⁶ Ω·cm aufweisen. Die Isolationsschicht kann zusätzlich auch chemisch inert sein und auf diese Weise eine weitere Oxidation des Substrates verhindern. Hierdurch wird der erfindungsgemäße Sensor langzeitstabil und eine Beeinflussung elektrischer bzw. elektronischer Komponenten auf bzw. im Substrat wird vermieden. Darüber hinaus kann die Isolationsschicht in einigen Ausführungsformen der Erfindung auch die Haftfestigkeit zwischen dem zumindest einen Wellenleiter und dem Substrat verbessern.

In einigen Ausführungsformen der Erfindung kann im Substrat zumindest ein Bauelement angeordnet sein. Ein solches Bauelement kann in einigen Ausführungsformen der Erfindung ausgewählt sein aus zumindest einer Leiterschleife und/oder zumindest einer Antenne und/oder zumindest einem Transistor und/oder zumindest einer Kapazität und/oder zumindest einem Widerstand und/oder zumindest einem optoelektronischen Bauteil. Ein solches Bauelement bzw. eine Mehrzahl von Bauelementen als integrierte Schaltung innerhalb des Substrates kann zur Signalerzeugung, zur Signalauslese oder zur Signalanalyse dienen. Beispielsweise kann auf dem Substrat eine Lichtquelle bzw. ein Lichtdetektor integriert sein, beispielsweise ein Halbleiterlaser, eine Leuchtdiode, eine Photodiode oder ein CCD-Detektor. In anderen Ausführungsformen der Erfindung kann auf dem Substrat eine Quelle für Mikrowellenstrahlung vorhanden sein, welche zumindest am Ort des NV-Zentrums eine Mikrowellenstrahlung erzeugt. Hierdurch kann der Spin-Zustand des NV-Zentrums von mₛ = 0 in mₛ = ±1 überführt werden, um die Photolumineszenz des NV-Zentrums vom Hell- in den Dunkelzustand zu bringen und dadurch ein Messsignal zu erzeugen. Hierzu kann im Substrat zumindest eine Antenne bzw. eine als Antenne wirkende Leiterschleife integriert sein, um auch mit geringer Sendeleistung und damit guter elektromagnetischer Verträglichkeit des erfindungsgemäßen Sensors eine hohe Feldstärke am Ort des NV-Zentrums zu erzeugen.

In einigen Ausführungsformen der Erfindung enthält der Sensor zumindest eine Elektrode, mit welcher zumindest am Ort des NV-Zentrums ein elektrisches Feld erzeugbar ist. Die zumindest eine Elektrode kann auf dem Wellenleiter angeordnet sein oder an zumindest einer Seitenfläche des Wellenleiters und/oder auf dem Substrat unter dem Wellenleiter. Ein im Wellenleiter zumindest am des Ort des NV-Zentrums induziertes elektrisches Feld kann eine Bandverbiegung bewirken, welche den negativen Ladungszustand des NV-Zentrums stabilisiert. Hierdurch kann die Erfassung des Magnetfeldes mit größerer Zuverlässigkeit erfolgen.

In einigen Ausführungsformen der Erfindung kann eine Mehrzahl von NV-Zentren im Wellenleiter angeordnet sein. In einigen Ausführungsformen der Erfindung kann die Mehrzahl von NV-Zentren etwa 10 bis etwa 40 oder etwa 20 bis etwa 30 NV-Zentren umfassen. Die NV-Zentren können eng benachbart im Diamant des Wellenleiters angeordnet sein und beispielsweise einen Abstand von etwa 1 bis etwa 1000 oder von etwa 10 bis etwa 500 Gitterkonstanten zueinander aufweisen. Hierdurch wird das Messsignal eines NV-Zentrums verstärkt, so dass das Signal-/Rauschverhältnis verbessert ist bei immer noch guter Ortsauflösung.

In einigen Ausführungsformen der Erfindung kann der Sensor weiterhin zumindest ein Filterelement enthalten, welches im Wellenleiter angeordnet ist. Das zumindest eine Filterelement kann dazu dienen, das Abfragesignal zur Auslese des NV-Zentrums zu monochromatisieren und/oder das vom NV-Zentrum ausgesandte Licht zu filtern und Störstrahlung anderer Frequenz zu unterdrücken. Hierdurch kann das Signal-/Rauschverhältnis verbessert und damit die Sensitivität des Sensors erhöht werden.

In einigen Ausführungsformen der Erfindung kann das Filterelement ausgewählt sein aus einem Singlemode-Wellenleiter und/oder einem Bragg-Gitter. Das Bragg-Gitter reflektiert Licht einer vorgebbaren Wellenlänge bzw. eines vorgebbaren Wellenlängenbereiches, welcher von der Gitterkonstante des Bragg-Gitters abhängt. Licht anderer Wellenlängen wird vom Bragg-Gitter weitgehend verlustfrei transmittiert.

Ein Singlemode-Wellenleiter ist dazu eingerichtet, Licht einer vorgebbaren Wellenlänge entlang seiner Längserstreckung zu transportieren, wohingegen Licht anderer Wellenlängen den Kern des Wellenleiters über dessen Begrenzungsflächen verlässt. Auf diese Weise können in einigen Ausführungsformen der Erfindung auch unterschiedliche Singlemode-Wellenleiter für die Zufuhr des optischen Signales zum NV-Zentrum und zur Verbindung des NV-Zentrums mit einem optischen Detektor verwendet werden. Dadurch kann Licht, welches nicht vom NV-Zentrum emittiert wird, zuverlässig vom Detektor ferngehalten und die Sensitivität weiter verbessert werden.

In einigen Ausführungsformen der Erfindung können die Wellenleiter bzw. zumindest ein Wellenleiter durch Strukturieren einer Diamantschicht auf einem Substrat hergestellt werden. Das zumindest eine NV-Zentrum kann nachfolgend durch Implantation von zumindest einem Stickstoff Ion in den Wellenleiter erzeugt werden. In Abhängigkeit der zur Implantation verwendeten kinetischen Energie des Ions wird das NV-Zentrum oberflächennah oder tiefer im Bulk-Material des Wellenleiters erzeugt. Hierdurch können die Eigenschaften des NV-Zentrums und dessen Beeinflussbarkeit durch äußere elektrische Felder an vorgebbare Anforderungen angepasst werden.

Um eine hinreichend gute Kristallqualität der Wellenleiter sicherzustellen, kann in einigen Ausführungsformen der Erfindung eine Diamantschicht homoepetaktisch auf einem Hilfssubstrat erzeugt und anschließend auf das Substrat des Sensors gebondet werden. Hierdurch kann ein kristalliner Diamant mit geringer Defektdichte bereitgestellt werden, so dass das im Wellenleiter transportierte Licht nur geringe Dämpfung erfährt und ein zuverlässiger Betrieb des erfindungsgemäßen Sensors ermöglicht wird.

In einigen Ausführungsformen der Erfindung kann das Erzeugen von zumindest einem Wellenleiter durch Strukturieren der Diamantschicht mittels Maskieren mit einer metallischen Maske und anschließendes Plasmaätzen erfolgen. Dadurch lassen sich Singlemode- und Multimode-Wellenleiter an genau definierten Stellen des Substrates erzeugen, so dass eine definierte Geometrie des Sensors hergestellt werden kann.

Nachfolgend soll die Erfindung anhand von Figuren ohne Beschränkung des allgemeinen Erfindungsgedankens näher erläutert werden. Dabei zeigt
Figur 1 eine schematische Darstellung eines NV-Zentrums.
Figur 2 zeigt ein Termschema eines NV-Zentrums.
Figur 3 zeigt die Fluoreszenz eines NV-Zentrums als Funktion anliegender Mikrowellenstrahlung.
Figur 4 zeigt einen Sensor gemäß der vorliegenden Erfindung in der Ansicht.
Figur 5 zeigt einen Sensor gemäß der vorliegenden Erfindung im Querschnitt.
Figur 6 zeigt einen Ausschnitt aus Figur 5 in vergrößerter Darstellung.
Figuren 7 bis 19 erläutern Verfahrensschritte zur Herstellung eines erfindungsgemäßen Sensors.

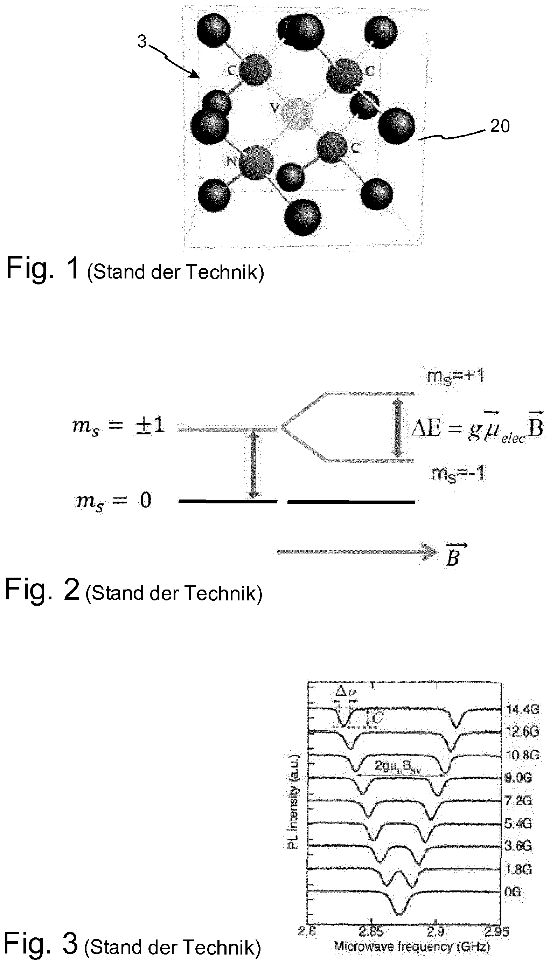

Anhand der Figur 1 wird die Struktur eines NV-Zentrums erläutert. Figur 1 zeigt einen Ausschnitt aus dem Kristallgitter von Diamant 20. Die Diamantstruktur ist durch ein fcc-Gitter mit zweiatomiger Basis charakterisiert. Das ungestörte einkristalline Diamantgitter besteht ausschließlich aus sp³-hybridisiertem Kohlenstoff.

Ein NV-Zentrum 3 wird durch ein Stickstoffatom gebildet, welches einen Gitterplatz eines Kohlenstoffatoms einnimmt. In Figur 1 ist das Stickstoffatom mit N bezeichnet.

Benachbart zum Stickstoffatom findet sich eine Leerstelle bzw. Vakanz V. Die nächsten Nachbarn der Leerstelle V sind somit drei Kohlenstoffatome C und ein Stickstoffatom N. Die Störung des Kristallgitters durch eine Leerstelle und ein benachbartes Stickstoffatom gibt dem NV-Zentrum seinen Namen.

Der Vakanz V sind somit fünf Elektronen zugeordnet, nämlich drei Bindungselektronen der benachbarten Kohlenstoffatome sowie zwei Elektronen des Stickstoffatoms. Darüber hinaus kann das NV-Zentrum negativ geladen sein, so dass dem NV-Zentrum sechs Elektronen zugeordnet sind.

Die zwei ungebundenen Elektronen des negativ geladenen NV-Zentrums bilden einen Triplett-Zustand. Dieser besteht aus einem Spin-Singulett mit mₛ = 0 und einem Dublett mit mₛ = _{±}1. Das Termschema dieses Tripletts ist in Figur 2 dargestellt.

Wie Figur 2 zeigt, sind die Dublett-Zustände mₛ = ±1 energetisch entartet, d.h. beide Zustände weisen dieselbe Energie auf. Spin-Singulett und Spin-Dublett sind energetisch getrennt. Die Separation beträgt 12 µeV. Übergänge zwischen beiden Zuständen können somit durch Mikrowellenstrahlung mit einer Frequenz von 2,88 GHz angeregt werden.

Wie Figur 2 weiter zeigt, wird die Entartung des Dubletts aufgehoben, wenn das NV-Zentrum einem Magnetfeld ausgesetzt wird. Parallele und antiparallele Ausrichtung des Spins zum externen Magnetfeld sind um die Energie ΔE voneinander separiert. Der Betrag ΔE ist proportional zum Magnetfeld und beträgt ΔE = g·µ·B. Dabei bezeichnet g den gyromagnetischen Faktor, d.h. den Quotient aus der Größe des gemessenen magnetischen Moments und dem theoretisch erwarteten magnetischen Moment, µ bezeichnet das Bor'sche Magneton und B das Magnetfeld. Somit kann aus der Messung der energetischen Aufspaltung des Spin-Dubletts das Magnetfeld bestimmt werden.

Figur 3 zeigt die Intensität der Photolumineszenz auf der Ordinate und die Frequenz eingestrahlter Mikrowellenstrahlung auf der Abszisse. Aus den in Figur 3 gezeigten Messwerten für unterschiedliche magnetische Felder ist ersichtlich, dass mit zunehmender Aufspaltung des Spin-Dubletts aufgrund des Zeemann-Effekts eine Intensitätsabnahme bei 2,88 GHz beobachtet wird. In der optischen Emission als Funktion der Mikrowellenfrequenz entstehen bei zunehmendem Magnetfeld 2 Minima, welche proportional zum angelegten externen magnetischen Feld sind. Der Abstand dieser beiden Minima kann als Maß für das am Ort des NV-Zentrums herrschende Magnetfeld herangezogen werden. Auf diese Weise kann das NV-Zentrum im Diamantkristall als Magnetfeldsensor herangezogen werden.

Die Erfindung löst primär die Aufgabe, eine zuverlässige Signalerzeugung und -Erfassung zu ermöglichen und einen kompakten, mechanisch robusten Sensor bereitzustellen, welcher mit geringem apparativen Aufwand betrieben werden kann.

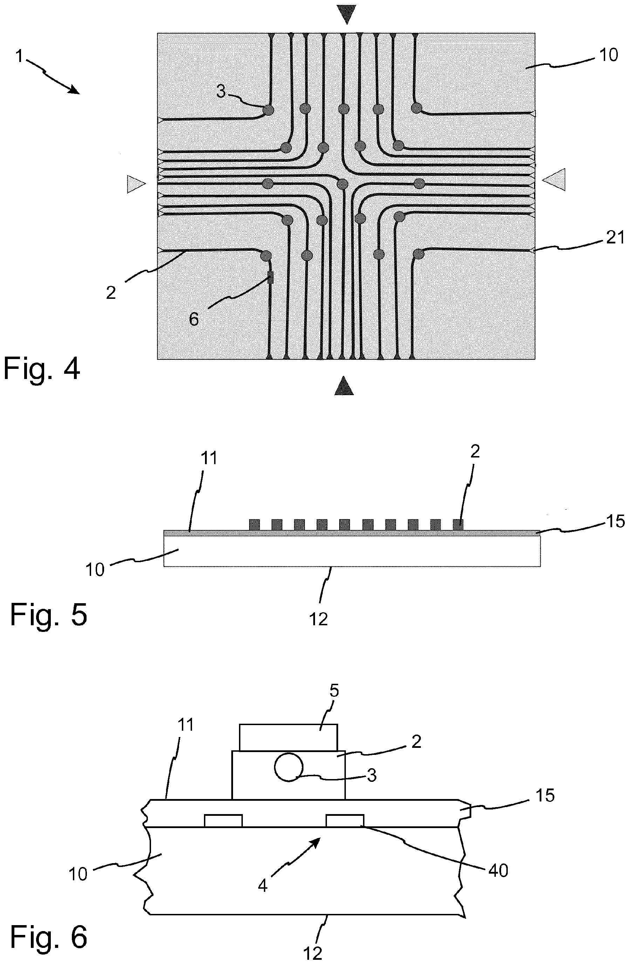

Wie in Figur 4 dargestellt ist, wird erfindungsgemäß vorgeschlagen, den Sensor auf einem Substrat 10 aufzubauen. Das Substrat 10 trägt zumindest einen Wellenleiter 2. Der Wellenleiter 2 enthält Diamant bzw. besteht in einigen Ausführungsformen der Erfindung vollständig aus Diamant. Im Wellenleiter 2 ist zumindest ein NV-Zentrum 3 angeordnet. Wie in Figur 4 dargestellt ist, können auch mehrere NV-Zentren in mehreren Wellenleitern verwendet werden, um eine räumliche Verteilung eines Magnetfeldes zu erfassen. Unterschiedliche Messorte können dabei durch unterschiedliche Wellenleiter und/oder durch die Laufzeit optischer Signale im Wellenleiter adressiert werden.

Im Einzelnen zeigen die Figuren 4 und 5 ein Substrat 10, welches beispielsweise Silizium, Siliziumcarbid, eine Oxidkeramik oder einen III-V-Verbindungshalbleiter enthalten kann. Das Substrat 10 kann selbst wiederum aus einer Mehrzahl von Einzelschichten zusammengesetzt und optional auch lateral strukturiert sein, so dass das Substrat 10 auch eine integrierte optische Komponente oder eine integrierte elektronische Schaltung enthalten kann. Eine solche Schaltung kann beispielsweise Teile der Signalauslese der Magnetfeldsensoren enthalten. Beispielsweise kann eine Lichtquelle oder ein Lichtempfänger auf dem Substrat 10 integriert sein. Daneben kann das Substrat 10 selbstverständlich weitere optische oder elektronische Komponenten enthalten, beispielsweise ein Spektrometer, einen Verstärker, einen Diskriminator, einen A/D-Wandler oder weitere, an sich bekannte Komponenten.

Das Substrat 10 weist eine erste Seite 11 und eine gegenüberliegende zweite Seite 12 auf. Im dargestellten Ausführungsbeispiel sind die Wellenleiter 2 auf der ersten Seite 11 angeordnet. In anderen Ausführungsformen der Erfindung können die Wellenleiter 2 auch auf der zweiten Seite oder beidseitig aufgebracht werden.

Zwischen den Wellenleitern 2 und dem Substrat 10 befindet sich eine beispielhaft dargestellte Isolationsschicht 15. Die Isolationsschicht 15 kann beispielsweise ein Nitrid, ein Oxid oder ein Oxynitrid enthalten. Diese kann eine elektrische Isolation zwischen Substrat und Wellenleiter 2 bewirken, die Haftfestigkeit der Wellenleiter 2 auf dem Substrat 10 sicherstellen oder weitere, hier nicht näher genannte Aufgaben übernehmen. Es ist darauf hinzuweisen, dass die Isolationsschicht 15 optional ist und in anderen Ausführungsformen der Erfindung auch entfallen kann.

Wie in Figur 4 dargestellt ist, sind die Wellenleiter im dargestellten Ausführungsbeispiel jeweils um 90° gekrümmt, so dass Eingang und Ausgang an unterschiedlichen Seitenkanten des in etwa quadratischen Substrates angeordnet sind. In anderen Ausführungsformen der Erfindung können die Wellenleiter auch jede andere Geometrie annehmen. In einigen Ausführungsformen der Erfindung können die Wellenleiter an ihrem Ende auch verspiegelt sein, so dass im Pulsbetrieb über jeweils ein Koppelelement Licht ein- bzw. ausgekoppelt werden kann.

Die Wellenleiter 2 weisen jeweils eine Dicke von etwa 3 µm bis etwa 6 µm auf. Die Breite der Wellenleiter ist so gewählt, dass diese entweder als Singlemode-Wellenleiter oder als Multimode-Wellenleiter ausgeführt sind. Hierdurch kann Licht vorgebbarer Wellenlängen gefiltert werden. Dies kann das Signal-/Rauschverhältnis positiv beeinflussen.

Die Wellenleiter 2 enden an jeweils zumindest einem zugeordneten Koppelelement 21, über welches Licht einer an sich bekannten Lichtquelle eingekoppelt werden kann. Die Lichtquelle kann beispielsweise ein Halbleiterlaser, eine Superlumineszenzdiode, eine Leuchtdiode oder eine andere, an sich bekannte Lichtquelle umfassen. Die Lichtquelle kann Licht mit einer Wellenlänge zwischen 560 und etwa 590 nm aussenden. In einigen Ausführungsformen der Erfindung kann die Lichtquelle Licht mit einer Frequenz von etwa 570 bis 580 bzw. Licht mit einer Wellenlänge von 575 nm aussenden.

Weiterhin zeigt Figur 4 ein optionales Filterelement 6, welches das vom NV-Zentrum ausgesandte Licht filtert. Somit werden Störwellenlängen vom Lichtempfänger ferngehalten, so dass die Genauigkeit der Messung ansteigen kann. Das Filterelement 6 kann ein an sich bekanntes Bragg-Gitter, einen Singlemode-Wellenleiter, einen Farbstoff, einen Interferenzfilter oder jedes andere, an sich bekannte Filterelement enthalten.

Zur Messung eines Magnetfeldes wird den Wellenleitern 2 Licht zugeführt, welches nachfolgend innerhalb der Wellenleiter 2 propagiert. Hierdurch wird das negativ geladene NV-Zentrum zum Leuchten angeregt, wobei gleichzeitig die NV-Zentren 3 einer Mikrowellenstrahlung ausgesetzt sind. Bei Anwesenheit eines magnetischen Feldes nimmt die Intensität des detektierten Lichtes bei einer Frequenz von 2,88 GHz zu und bei benachbarten Frequenzen ab, wie anhand der Figur 3 bereits erläutert wurde. Somit lassen sich mit dem erfindungsgemäßen Sensor mit einem kompakten, mechanisch robusten Aufbau Magnetfelder an einer Vielzahl von Orten und mit hoher Sensitivität messen. Der erfindungsgemäße Sensor 4 eignet sich daher neben einer Vielzahl technischer Anwendungen auch für die Bestimmung von schwachen Magnetfeldern, welche von Lebewesen ausgesandt werden. Beispielsweise kann der erfindungsgemäße Sensor zur Magnetoenzephalographie verwendet werden.

Figur 6 zeigt einen Ausschnitt aus Figur 5 in Vergrößerung. Dargestellt ist wiederum ein Substrat 10 mit einer ersten Seite 11 und einer gegenüberliegenden zweiten Seite 12. Auf dem Substrat 10 befindet sich ein Wellenleiter 2, welcher auf einer Isolationsschicht 15 angeordnet ist. Im Wellenleiter 2 befindet sich ein NV-Zentrum 3. Das NV-Zentrum 3 kann oberflächennah eingebracht sein, beispielsweise in einer Tiefe zwischen etwa 20 nm und etwa 100 nm oder zwischen etwa 40 nm und etwa 60 nm.

Da die Messung eines Magnetfeldes erfordert, dass das NV-Zentrum 3 negativ geladen ist, kann durch ein externes magnetisches Feld verhindert werden, dass Ladung aus dem NV-Zentrum abfließt. Hierzu zeigt Figur 6 eine Elektrode 5, welche auf der Oberseite des Wellenleiters 2 angeordnet ist. Die Elektrode 5 kann mit einer Spannungsquelle verbunden sein, um auf diese Weise ein elektrisches Feld im Wellenleiter 2 zu erzeugen. Das elektrische Feld 2 kann eine Bandverbiegung erzeugen, welche das Abfließen von Ladung aus dem NV-Zentrum 3 verhindert oder reduziert.

Weiterhin zeigt der Querschnitt gemäß Figur 6 ein elektronisches Bauelement 4, welches innerhalb des Substrates 10 oder auf dessen unmittelbarer Oberfläche angeordnet und in der Isolationsschicht 15 eingebettet sein kann. Im dargestellten Ausführungsbeispiel umfasst das Bauelement 4 zwei Leiterbahnen 40, welche aus einem elektrisch leitfähigen Material hergestellt sind. Beispielsweise können die Leiterbahnen 40 ein Metall oder eine Legierung enthalten, welche auf dem Substrat 10 abgeschieden und nachfolgend durch Maskieren und Ätzen strukturiert wurden. Die Leiterbahnen 40 können als Ringantenne verwendet werden, um elektromagnetische Wechselfelder am Ort des NV-Zentrums 3 zu erzeugen.

Auf diese Weise kann jedes NV-Zentrum 3 mit Mikrowellenstrahlung beaufschlagt werden, um eine zuverlässige Messung des jeweils dort herrschenden Magnetfeldes zu ermöglichen.

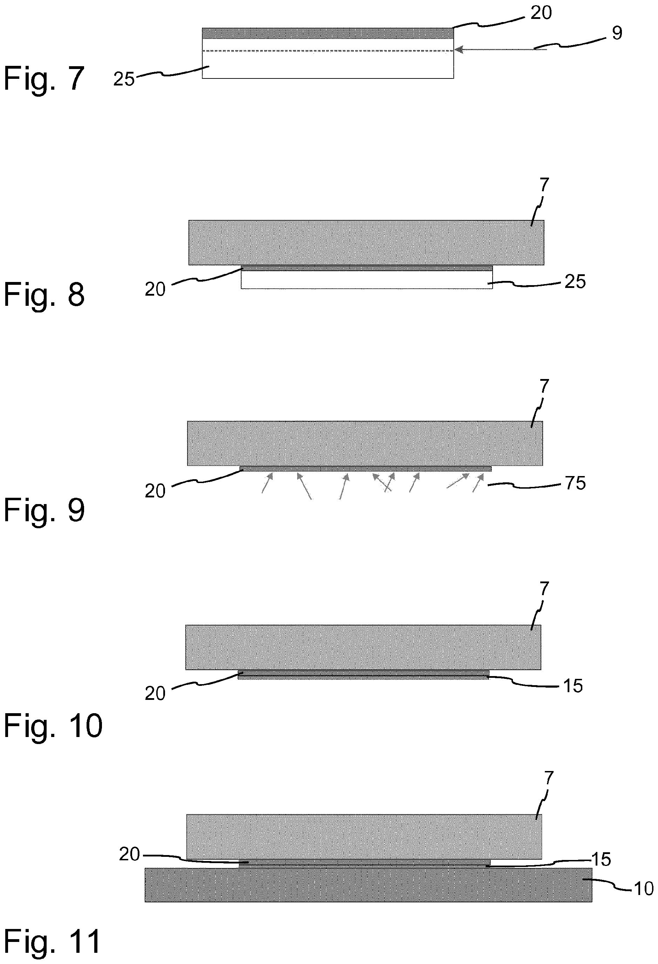

Anhand der Figuren 7 bis 19 werden Verfahrensschritte erläutert, welche die Herstellung eines erfindungsgemäßen Sensors ermöglichen. Das Herstellungsverfahren ist dabei beispielhaft zu sehen. Selbstverständlich kann der vorgeschlagene Sensor auch in anderer Weise hergestellt werden.

Figur 7 erläutert die Herstellung von Diamant 20 auf einem Hilfssubstrat 25. Im dargestellten Ausführungsbeispiel ist das Hilfssubstrat 25 ein einkristalliner Diamant. Der Diamant 20, welcher später zum Teil den Wellenleiter 2 bildet, kann auf dem Hilfssubstrat 25 homoepitaktisch aus der Gasphase abgeschieden werden. Hierzu stehen mehrere, an sich bekannte Verfahren zur Verfügung. Beispielsweise kann die Diamantschicht 20 durch Hot-filament-CVD oder durch Plasma-enhanced-CVD erzeugt werden. Diese Verfahren sind dem Fachmann geläufig. Die Erfindung lehrt nicht die Verwendung eines speziellen Herstellungsverfahrens für Diamant 20 als Lösungsprinzip.

Nachfolgend wird die Diamantschicht 20 vom Hilfssubstrat 25 getrennt. Dies kann beispielsweise durch Laserstrahlung 9 erfolgen, welche die Bindungen innerhalb des Hilfssubstrates 25 aufbricht und einen Trennschnitt erzeugt.

Zur Weiterverarbeitung der Diamantschicht 20 wird diese auf einen Träger 7 befestigt. Die Befestigung auf dem Träger 7 kann beispielsweise mit einem Wachs, einem Epoxidharz, einem Lot oder einem anderen, an sich bekannten Bindemittel erfolgen. Der Träger 7 kann beispielsweise ein Silizium-Wafer sein oder einen solchen enthalten. In anderen Ausführungsformen der Erfindung eignet sich für den Träger 7 auch jede andere plane Materiallage aus einem Metall, einer Legierung, einer Keramik oder einem Glas.

Figur 9 zeigt den nächsten Verfahrensschritt, nämlich das vollständige Entfernen des Hilfssubstrates 25. Hierzu wird ein nass- oder trockenchemisches Ätzen verwendet, wobei ein Ätzmittel 75 auf die nicht vom Träger 7 bedeckte Oberfläche der Diamantschicht einwirkt und auf diese Weise das Hilfssubstrat 25 vollständig entfernt. Es ist darauf hinzuweisen, dass alternativ zum dargestellten Ätzverfahren das Entfernen des Hilfssubstrates 25 auch dadurch erfolgen kann, dass der in Figur 7 gezeigte Trennschnitt näher an der Oberfläche des Hilfssubstrates 25 oder sogar innerhalb der Diamantschicht 20 erfolgen kann. In anderen Ausführungsformen der Erfindung kann das Hilfssubstrat 25 auch spanend entfernt werden, beispielsweise durch Schleifen bzw. Polieren. In einigen Ausführungsformen der Erfindung kann das Hilfssubstrat 25 auch ganz oder teilweise an der Diamantschicht 20 verbleiben.

Nachdem das Hilfssubstrat 25 entfernt wurde, wird auf die freie Oberfläche der Diamantschicht 20 die Isolationsschicht 15 aufgetragen. Dies ist anhand von Figur 10 erläutert. Die Isolationsschicht 15 kann beispielsweise Siliziumoxid enthalten. Eine solche Isolationsschicht kann durch einen Sputterprozess aus der Gasphase abgeschieden werden. In anderen Ausführungsformen der Erfindung können neben Sputterverfahren auch andere, an sich bekannte Verfahren zur Schichtabscheidung verwendet werden, beispielsweise Chemical Vapor Deposition oder Physical Vapor Deposition.

Figur 11 zeigt das Aufbringen eines Substrates 10 auf die Isolationsschicht 15. Das Substrat 10 kann beispielsweise durch Waferbonden mit der Isolationsschicht 15 verbunden werden. In anderen Ausführungsformen der Erfindung kann selbstverständlich die Isolationsschicht 15 auch zunächst auf das Substrat 10 aufgebracht und dann auf die Diamantschicht 20 gebondet werden. Erfindungswesentlich ist eine Verbindung zwischen der Diamantschicht 20 und dem Substrat 10 mit oder ohne dazwischen angeordnete Isolationsschicht 15. Zur Erreichung dieses Zieles sind dem Fachmann eine Vielzahl von Verfahren geläufig.

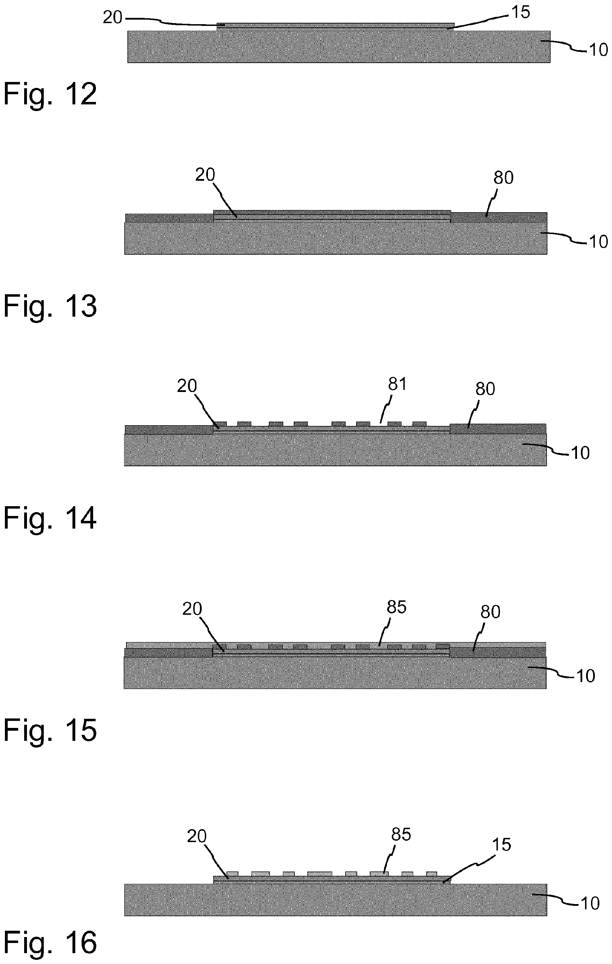

Figur 12 zeigt schließlich das entstandene Halbzeug nach dem Entfernen des Trägers 7. Hierzu kann die Diamantschicht 20 mit dem Substrat 10 erwärmt werden, um die Haltekräfte zwischen einem Wachs bzw. einem Klebstoff oder einem Lot und dem Träger 7 soweit zu reduzieren, dass der Träger beschädigungsfrei abgenommen werden kann. Daran kann sich ein optionaler Reinigungsschritt anschließen, um eine saubere Oberfläche der Diamantschicht 20 sicher zu stellen.

Figur 13 zeigt das Aufbringen eines Photolackes 80. Der Photolack 80 kann aus einem Polymer bestehen oder ein solches enthalten. Der Photolack 80 kann beispielsweise durch Spin-Coaten, Drucken, Rakeln oder andere, an sich bekannte Verfahren aufgebracht werden.

Nach dem Aushärten des Photolackes 80 kann dieser durch Belichten mittels einer Maske und nachfolgendes entwickeln und Ätzen strukturiert werden, so dass sich erste Teilflächen ergeben, welche mit dem Photolack bedeckt sind und zweite Teilflächen 81 verbleiben, von welchen der Photolack entfernt ist. Dies ist in Figur 14 dargestellt.

Nachfolgend wird das Substrat 10 mit einer Metallisierung 85 versehen, welche in Figur 15 dargestellt ist. Die Metallisierung 85 kann beispielsweise durch Sputtern eines reinen Metalltargets, durch chemisches Aufdampfen, durch Ionenplattieren oder andere, an sich bekannte Verfahren erzeugt werden. Die Metallisierung 85 kann eine Mehrzahl von Einzelschichten enthalten, welche beispielsweise zur Haftverbesserung verwendbar sind.

Figur 16 zeigt den Querschnitt durch das Substrat 10 und die Diamantschicht 20, nachdem der Photolack 80 entfernt wurde. Dies bewirkt darüber hinaus auch, dass die auf dem Photolack 80 befindliche Teilfläche der Metallisierung 85 entfernt wird, so dass nun Teilflächen der Diamantschicht 20 freiliegen und andere Teilflächen der Diamantschicht 20 mit der Metallisierung 85 bedeckt sind.

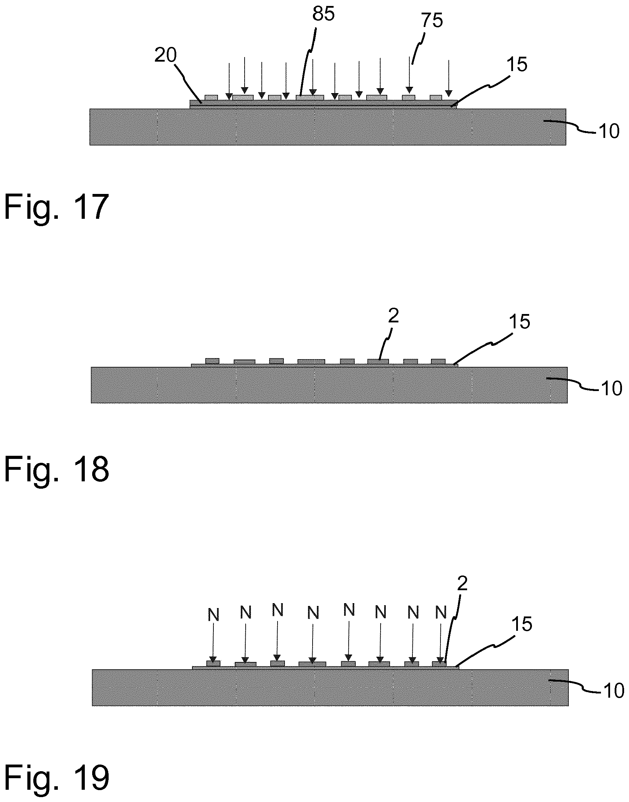

Wie in Figur 17 erläutert wird, folgt daraufhin wiederum ein nass- oder trockenchemisches Ätzen. In einigen Ausführungsformen der Erfindung kann das Ätzen durch ein Plasma erfolgen. Das Ätzmittel 75 greift somit die unbedeckten Teilflächen der Diamantschicht 20 an. Die von der Metallisierung 85 geschützten Teilflächen werden hingegen vom Ätzmittel 75 nicht angegriffen.

Figur 18 zeigt den Querschnitt durch den Sensor nach Entfernen der Metallisierung 85. Zu diesem Zeitpunkt sind somit auf dem Substrat 10 Wellenleiter 2 angeordnet, welche aus einkristallinen Diamant mit hoher Kristallqualität bestehen. Das einkristalline, defektarme Material des Diamants 20 weist gegenüber polykristallinem Diamant eine geringe Defektdichte auf, so dass innerhalb des Wellenleiters 2 propagierendes Licht eine geringere Schwächung erfährt. In anderen Ausführungsformen der Erfindungkann die Metallisierung ach ganz oder Teilweise verbleiben, um als Elektrode 5 verwendet zu werden.

Im letzten Verfahrensschritt 19 wird schließlich an vorgebbaren Stellen innerhalb der Wellenleiter 2 Stickstoff implantiert, um zumindest ein NV-Zentrum zu erzeugen. Die Implantation des Stickstoffs kann dabei über eine nicht dargestellte Maske erfolgen, so dass bei vollflächiger Bestrahlung des Substrates 10 nur wenige Stickstoffatome an definierten Stellen der Wellenleiter 2 implantiert werden. In anderen Ausführungsformen der Erfindung können beschleunigte Stickstoffionen über magnetische Linsen fokussiert und an definierten Stellen der Wellenleiter 2 implantiert werden. Schließlich können Stickstoffionen in einigen Ausführungsformen der Erfindung auch durch AFM-Spitzen an definierten Stellen der Wellenleiter 2 implantiert werden. Hierdurch bilden sich an vorgebbaren Stellen NV-Zentren, so dass an diesen Stellen ein Magnetfeld gemessen werden kann. Die Anzahl der erzeugten Wellenleiter und die Anzahl der NV-Zentren definiert dabei die Ortsauflösung des erfindungsgemäßen Magnetfeldsensors.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Aus-führungsformen definieren, so dient diese Bezeichnung der Unterscheidung zweier gleichartiger Ausführungsformen, ohne eine Rangfolge festzulegen.

## Patentansprüche

1. Sensor (1) mit einem Substrat (10) mit einer ersten Seite (11) und einer gegenüberliegenden zweiten Seite (12), wobei auf der ersten Seite zumindest ein Wellenleiter (2) angeordnet ist, welcher Diamant (20) enthält oder daraus besteht, wobei
im Wellenleiter (2) zumindest ein NV-Zentrum (3) angeordnet ist,
das Substrat (10) Siliziumoxid und/oder Siliziumnitrid und/oder Siliziumoxinitrid und/oder Siliziumcarbid und/oder Silizium enthält oder daraus besteht,
das Substrat ein Bauelement enthält, das ausgewählt ist aus zumindest einer Leiterschleife und/oder zumindest einer Antenne (40) und/oder zumindest einem Transistor und/oder zumindest einer Kapazität und/oder zumindest einem Widerstand und/oder zumindest einem optoelektronischen Bauteil, und die Diamantschicht (20) homoepitaktisch auf einem Hilfssubstrat erzeugt und auf das Substrat (10) gebondet ist und die Diamantschicht (20) einkristallinen Diamant enthält, **gekennzeichnet dadurch, dass** der Sensor zumindest eine Elektrode (5) auf der Oberseite des Wellenleiters (2)enthält, mit welcher zumindest am Ort des NV-Zentrums (3)ein elektrisches Feld erzeugbar ist.

2. Sensor nach Anspruch 1, **dadurch gekennzeichnet, dass** der Wellenleiter (2) eine Dicke von etwa 3 µm bis etwa 6 µm aufweist.

3. Sensor nach einem der Ansprüche 1 oder 2, **dadurch gekennzeichnet, dass** zwischen dem Substrat (10) und dem Wellenleiter (2) eine Isolationsschicht (15) angeordnet ist.

4. Sensor nach einem der Ansprüche 1 bis 3, weiterhin enthaltend eine Mehrzahl von NV-Zentren (3), insbesondere etwa 10 bis etwa 40 oder etwa 20 bis etwa 30.

5. Sensor nach einem der Ansprüche 1 bis 4, weiterhin enthaltend zumindest ein Filterelement, welches im Wellenleiter (2) angeordnet ist.

6. Sensor nach Anspruch 5, **dadurch gekennzeichnet, dass** das Filterelement (6) ausgewählt ist aus einem single-mode Wellenleiter und/oder einem Bragg-Gitter.

7. Verfahren zur Messung eines Magnetfeldes mit einem Sensor (1) nach einem der Ansprüche 1 bis 6, bei welchem ein NV-Zentrum (3) in einem Wellenleiter (2) angeordnet ist und mit Mikrowellenstrahlung variabler Frequenz beaufschlagt wird und dessen Photolumineszenz bestimmt wird, indem Licht in den Wellenleiter (2) eingekoppelt wird.

8. Verfahren nach Anspruch 7, **dadurch gekennzeichnet, dass** zumindest am Ort des NV-Zentrums (3) ein elektrisches Feld erzeugt wird.

9. Verfahren zur Herstellung eines Sensors nach einem der Ansprüche 1 bis 6, enthaltend folgende Schritte:
Herstellen einer Diamantschicht (20) auf einem Substrat (10)
Erzeugen zumindest eines Wellenleiters (2) durch Strukturieren der Diamantschicht (20)
Einbringen von zumindest einem NV-Zentrum (3) durch Implantation von zumindes einem Stickstoff-Ion in den Wellenleiter (2).

10. Verfahren nach Anspruch 9 **dadurch gekennzeichnet, dass** das Strukturieren der Diamantschicht durch Maskieren mit einer metallischen Maske (85) und anschließendes Plasmaätzen erfolgt.

## Claims

1. Sensor (1) having a substrate (10) having a first side (11) and an opposite second side (12), wherein at least one waveguide (2) containing or consisting of diamond (20) is arranged on the first side, wherein
at least one NV centre (3) is arranged in the waveguide (2),
the substrate (10) contains or consists of silicon oxide and/or silicon nitride and/or silicon oxynitride and/or silicon carbide and/or silicon, the substrate contains a component selected from at least one conductor loop and/or at least one antenna (40) and/or at least one transistor and/or at least one capacitance and/or at least one resistor and/or at least one optoelectronic component, and
the diamond layer (20) is homoepitaxially produced on an auxiliary substrate and bonded onto the substrate (10) and
the diamond layer (20) contains monocrystalline diamond, **characterized in that** the sensor contains at least one electrode (5) on the top side of the waveguide (2), an electric field being able to be generated by means of said at least one electrode at least at the location of the NV centre (3).

2. Sensor according to Claim 1, **characterized in that** the waveguide (2) has a thickness of approximately 3 µm to approximately 6 µm.

3. Sensor according to either of Claims 1 and 2, **characterized in that** an insulation layer (15) is arranged between the substrate (10) and the waveguide (2).

4. Sensor according to any of Claims 1 to 3, furthermore containing a plurality of NV centres (3), in particular approximately 10 to approximately 40 or approximately 20 to approximately 30.

5. Sensor according to any of Claims 1 to 4, furthermore containing at least one filter element arranged in the waveguide (2).

6. Sensor according to Claim 5, **characterized in that** the filter element (6) is selected from a single-mode waveguide and/or a Bragg grating.

7. Method for measuring a magnetic field using a sensor (1) according to any of Claims 1 to 6, wherein an NV centre (3) is arranged in a waveguide (2) and is impinged on by microwave radiation of variable frequency and its photoluminescence is determined by light being coupled into the waveguide (2).

8. Method according to Claim 7, **characterized in that** an electric field is generated at least at the location of the NV centre (3).

9. Method for producing a sensor according to any of Claims 1 to 6, containing the following steps:
producing a diamond layer (20) on a substrate (10) ,
producing at least one waveguide (2) by structuring the diamond layer (20),
introducing at least one NV centre (3) into the waveguide (2) by implanting at least one nitrogen ion.

10. Method according to Claim 9, **characterized in that** structuring the diamond layer is carried out by masking with a metallic mask (85) and subsequent plasma etching.

## Revendications

1. Détecteur (1) comprenant un substrat (10) avec un premier côté (11) et un deuxième côté opposé (12),
dans lequel, sur le premier côté, est agencé au moins un guide d'onde (2) qui contient du diamant (20) ou qui en est constitué, dans lequel au moins un centre NV (azote-lacune) (3) est agencé dans le guide d'onde (2),
le substrat (10) contient de l'oxyde de silicium et/ou du nitrure de silicium et/ou de l'oxynitrure de silicium et/ou du carbure de silicium et/ou du silicium, ou en est constitué,
le substrat contient un composant qui est sélectionné parmi au moins une boucle conductrice et/ou au moins une antenne (40) et/ou au moins un transistor et/ou au moins un condensateur et/ou au moins une résistance et/ou au moins un élément optoélectronique, et la couche de diamant (20) est produite de manière homoépitaxiale sur un substrat auxiliaire et est liée sur le substrat (10), et
la couche de diamant (20) contient du diamant monocristallin,
**caractérisé en ce que** le détecteur contient au moins une électrode (5) sur le côté supérieur du guide d'onde (2), permettant de générer un champ électrique au moins à l'emplacement du centre NV (3).

2. Détecteur selon la revendication 1, **caractérisé en ce que** le guide d'onde (2) présente une épaisseur de 3 µm environ à 6 µm environ.

3. Détecteur selon l'une des revendications 1 ou 2, **caractérisé en ce qu'**une couche d'isolation (15) est agencée entre le substrat (10) et le guide d'onde (2).

4. Détecteur selon l'une des revendications 1 à 3, comprenant en outre une pluralité de centres NV (3), en particulier de 10 environ à 40 environ, ou de 20 environ à 30 environ.

5. Détecteur selon l'une des revendications 1 à 4, comprenant en outre au moins un élément de filtre qui est agencé dans le guide d'onde (2).

6. Détecteur selon la revendication 5, **caractérisé en ce que** l'élément de filtre (6) est sélectionné parmi un guide d'onde monomode et/ou un réseau de Bragg.

7. Procédé de mesure d'un champ magnétique avec un détecteur (1) selon l'une des revendications 1 à 6, dans lequel un centre NV (3) est agencé dans un guide d'onde (2) et est exposé à un rayonnement micro-ondes à fréquence variable et dont la photoluminescence est déterminée en injectant de la lumière dans le guide d'onde (2).

8. Procédé selon la revendication 7,
**caractérisé en ce que**
un champ électrique est généré au moins à l'emplacement du centre NV (3).

9. Procédé de réalisation d'un détecteur selon l'une des revendications 1 à 6, comprenant les étapes consistant à :
réaliser une couche de diamant (20) sur un substrat (10) ;
générer au moins un guide d'onde (2) par structuration de la couche de diamant (20) ;
introduire au moins un centre NV (3) par implantation d'au moins un ion d'azote dans le guide d'onde (2).

10. Procédé selon la revendication 9,
**caractérisé en ce que**
la structuration de la couche de diamant s'effectue par masquage avec un masque métallique (85), puis par gravure au plasma.
